# EUROPÄISCHE PATENTSCHRIFT

(11) **EP 0 680 660 B1**
(45) Veröffentlichungstag und Bekanntmachung des Hinweises auf die Patenterteilung: **05.03.1997**
(21) Anmeldenummer: 94901759.4
(22) Anmeldetag: 15.12.1993
(51) Int. Cl.: H01H 13/70

(54) **LEITLACK-KONTAKTFLÄCHE**
CONDUCTIVE LACQUER CONTACT SURFACE
SURFACE DE CONTACT A VERNIS CONDUCTEUR

(30) Priorität: 25.01.1993 DE 4301928
(43) Veröffentlichungstag der Anmeldung: 08.11.1995
(73) Patentinhaber: Siemens Nixdorf Informationssysteme AG, 33106 Paderborn (DE)
(72) Erfinder: GUTMANN, Klaus, D-33102 Paderborn (DE); LÜCKEHE, Hans-Werner, D-33154 Salzkotten-Holsen (DE)
(74) Vertreter: Fuchs, Franz-Josef, Dr.-Ing.
(86) Internationale Anmeldenummer: DE9301197
(87) Internationale Veröffentlichungsnummer: WO9417541

(56) Entgegenhaltungen:
- EP-A- 0 481 335
- DE-A- 3 615 742
- US-A- 4 029 916
- US-A- 4 085 306

## Beschreibung

Die Erfindung betrifft eine Anordnung von Kontaktflächen für Schalter, Taster und Tastaturen.

Schalter, Taster oder Tastenfelder, insbesondere Eingabetastaturen für Datenverarbeitungsanlagen, werden häufig auf Trägerplatten aufgebaut. Dabei hat es sich als vorteilhaft erwiesen, als Trägerplatte eine Leiterplatte zu verwenden und feststehende Tastenkontakte als speziell geformte Leiterbahnen, sogenannte Kontaktflächen, auszuführen. Von dem beweglichen Teil der Taste wird eine Kontaktbrücke, häufig aus leitfähigem Gummi, beim Niederdrücken gegen die Kontaktflächen gedrückt.

Für die Kontaktflächen wird bereits eine Anordnung von zwei benachbarten Halbkreisen wie in der DE OS 37 14 382 benutzt. Dabei werden die aus Kupfer bestehenden Kontaktflächen auf der Oberfläche vergütet, weil sonst eine mögliche Korrosion die sichere Kontaktgabe verhindern würde. Als Oberflächenvergütung wird eine galvaisch aufgetragene Goldschicht verwendet. Um die hohen Fertigungskosten der Vergoldung zu vermeiden, wird auch ein beispielsweise durch Siebdruck aufgetragener Leitlack verwendet. Für Tastaturen mit erhöhten Anforderungen an die Kontaktsicherheit ist aber die Kontaktgabe dieser Anordnung nicht ausreichend sicher. Daher wird auch eine Form wie in US 4 818 828 benutzt, bei der die Kontaktflächen fingerförmig ineinandergreifen. Die Oberflächervergütung kann jedoch bei dieser Form durch Leitlacke im Siebdruck nur bei wenigen Fingern oder großen Tastenabständen erfolgen, da der mäanderförmige Zwischenraum zwischen den Fingern so schmal sein müßte, daß die Toleranzen des Druckverfahrens für den Leitlack keine zuverlässige Herstellung erlauben.

In dem Dokument US-A-4 029 916 wird ein Kontaktfeld gezeigt, dessen Kontaktflächen durch einen Stempel miteinander verbunden werden, symmetrisch um den Mittelpunkt des Kontaktfeldes angeordnet sind und bei dem diagonal gegenüberliegende Kontaktflächen miteinander verbunden sind. Die dargestellten Kontaktflächen sind jedoch von komplexer Form. Auch das Dokument DE-A-3 615 742 zeigt eine sehr komplexe Form der Kontaktelemente. Diese komplexen Formen der Kontaktelemente sind wie auch die fingerförmig ineinander greifenden Formen für übliche Tastenabstände nicht ohne weiteres einer Fertigung durch Leitlacke zugänglich.

Aufgabe der Erfindung ist es, Kontaktflächen so auszuführen, daß als Oberflächenvergütung Leitlacke einsetzbar sind und eine bessere Kontaktgabe als bei der Halbkreisform erreicht wird.

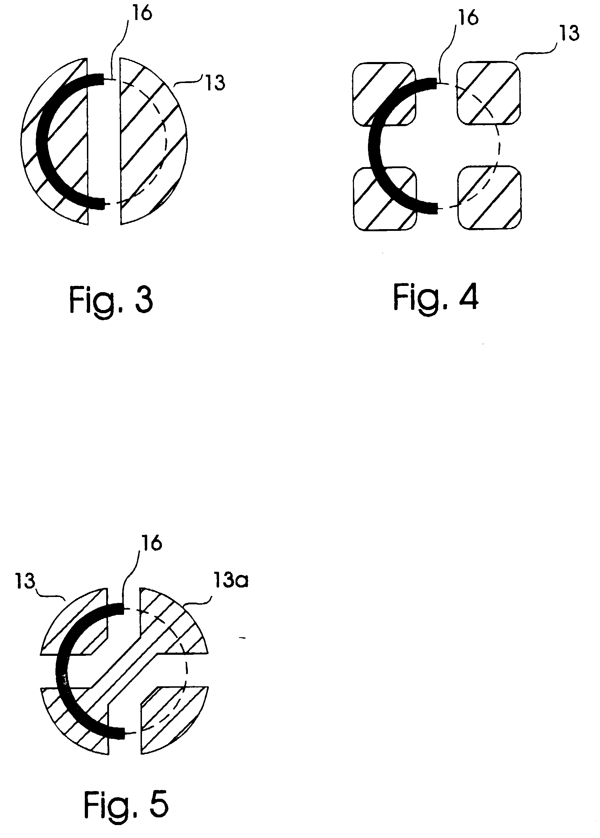

Die bevorzugte Ausführungsform der Erfindung verwendet ein Kontaktfeld aus vier Kontaktflächen auf den Ecken eines gedachten Quadrats, von denen je zwei diagonal gegenüberliegende elektisch miteinander verbunden sind. Damit sind jeweils benachbarte Kontaktflächen an verschiedene Pole des Schalters angeschlossen. Eine Kontaktgabe erfolgt also immer dann, wenn die Kontaktbrücke zwei benachbarte Kontaktflächen berührt. Wie in Fig. 4 dargestellt, wird so auch bei unvollständiger Tastenbetätigung, bei der nur der stark gezeichnete Teil der Kontaktbrücke wirksam ist, bereits ein Verbindung hergestellt, während unter den gleichen Bedingungen dies bei der bekannten Halbkreisanordnung nach Fig. 3 nicht der Fall ist. Die Zuverlässigkeit der Kontaktgabe ist damit erheblich verbessert, weil die Anzahl der möglichen Kontaktierungsflächen verdoppelt ist. Die Kontaktflächen können bei der erfindungsgemäßen Diagonalform so dimensioniert werden, daß sie, wie bei der bekannten Halbkreisanordnung, aus einem elektrisch leitfähigen Lack, vorzugsweise einem Karbonlack, hergestellt werden können, weil die Abstände groß genug sind, um Ungenauigkeiten eines einfachen Druckverfahrens zu toleriern. Sie werden überlappend über Kupfer-Pads aufgetragen, von denen aus der Anschluß durch eine geeignete Leiterplattenbahngestaltung erfolgt.

Eine vorteilhafte Weiterbildung besteht darin, ein Paar von Kontaktflächen innerhalb des Kontaktfeldes diagonal miteinander zu verbinden. Diese Verbindung trägt zur Kontaktgabe bei; zudem ist nur noch eine um das Kontaktfeld herumführende elektrische Verbindung notwendig.

Die Kontaktflächen werden bevorzugt quadratisch ausgestaltet, können aber auch als Kreissegmente ausgeführt werden. Gleichfalls sind mehr als vier, also beispielsweise sechs, Kontaktflächen möglich.

Da die Kontaktflächen mit Einrichtungen aufgetragen werden können, die bei jeder Leiterplattenfertigung beispielsweise für Bestückungsdruck ohnehin vorhanden sind, können nunmehr hochwertige Tastaturen in kürzerer Zeit und mit geringerem Aufwand gefertigt werden.

Die Erfindung wird an Hand der Zeichungen beschrieben.

Es zeigt
- Fig. 1: die Anordnung der Kontaktflächen in einem Kontaktfeld auf einer Leiterplatte in Draufsicht,
- Fig. 2: einen Schnitt durch die Anordnung nach Fig.1 entlang der Linie II-II, wobei zusätzlich ein Kontaktstempel mit Kontaktbrücke dargestellt ist,
- Fig. 3: Kontaktflächen der bekannten Anordnung in Halbkreisform mit dem Wirkungsbereich der Kontaktbrücke und markiertem Bereich für eine Teilkontaktierung,
- Fig. 4: Kontaktflächen in Diagonal-Anordnung, ansonsten wie Fig. 3,
- Fig. 5: vier Kreissegmente als Kontaktflächen, ansonsten wie Fig. 3,

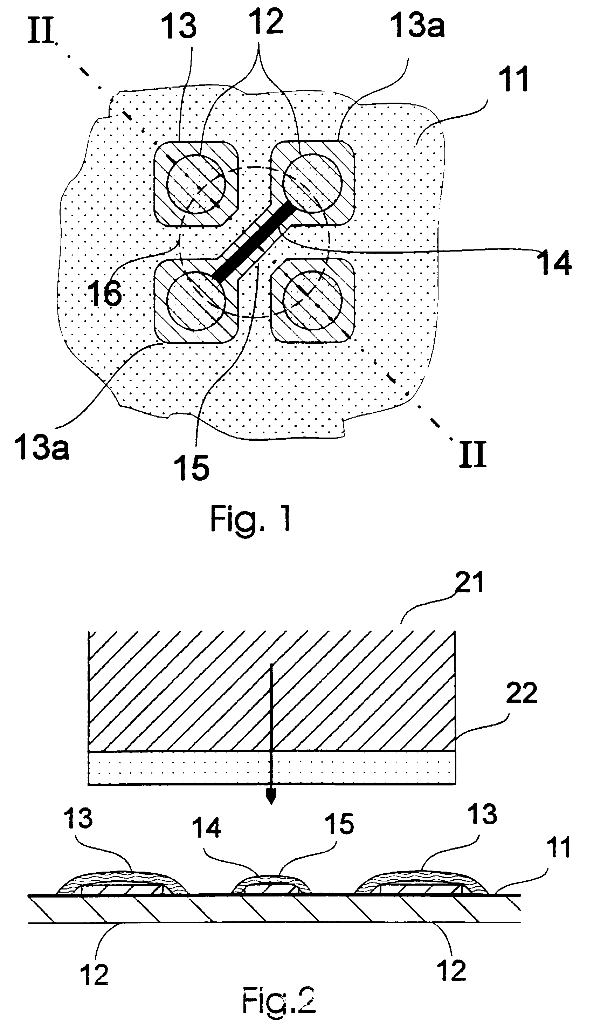

Nach Fig. 1 wird das Kontaktfeld einer Taste auf einem isolierenden Trägerplatte 11, vorzugsweise einer Leiterplatte, aufgebaut. Auf diese werden zunächst Kupferflächen 12 nach einem aus der Leiterplattenfertigung bekannten Verfahren aufgetragen. Diese Kupferflächen 12 sind kreisförmig und haben eine Durchmesser von etwa dem halben Durchmesser einer über ihnen angeordneten, durch Tastenbetätigung in bekannter Weise absenkbaren, kreisförmigen Kontaktbrücke 22, die auch in dem Schnitt II-II in Fig. 2 dargestellt ist und deren maximal mögliche Wirkungsfläche 16 als Kreis dargestellt ist. Die Mittelpunkte der Kupferflächen liegen etwas außerhalb des von der Kontaktbrücke erreichbaren Kreises. Die Kupferflächen werden durch nicht dargestellte Zuführungen elektrisch mit einer Auswerteschaltung verbunden. Auf die Kupferflächen 12 werden Kontaktflächen 13 aufgetragen, beispielsweise durch Siebdruck mit leitfähigen Lacken, vorzugsweise Karbonlack. Diese Kontaktflächen 13 überlappen die Kupferflächen 12 allseits und haften damit zusätzlich auf der Trägerplatte 11. Die Zuführungen werden in herkömmlicher Art durch einen Lötstoplack geschützt, der die Leiterplatte außerhalb der Kontaktflächen bedeckt und in den Abbildungen gleichfalls nicht dargestellt ist.

Zur Verdeutlichung des Unterschieds zwischen der erfindungsgemäßen Anordnung und dem Stand der Technik ist die bekannte Ausführung mit Halbkreisflächen in Fig. 3 dargestellt, wobei die maximal mögliche Wirkungsfläche 16 der Kontaktbrücke 22 als Kreis angedeutet ist. Als Beispiel für unvollständige Betätigung sei die Kontaktbrücke nur teilweise und am Rand wirksam, wie durch die Hervorhebung in Fig. 3 bis 6 dargestellt ist. Dieser Fall ist in Eingabetastaturen häufig, wenn die Tastenköpfe nur am Rand gedrückt werden. Während in diesem Fall bei der Anordung nach Fig. 3 keine Verbindung der Kontaktflächen erfolgt, wird bei der vereinfacht dargestellten Diagonalanordnung mit quadratischen Kontaktflächen in Fig. 4 eine Verbindung erreicht.

Gleiches gilt für die alternativen Ausführungsformen mit Kreissegmenten nach Fig. 5.

Wie in Fig. 1 und 5 dargestellt, wird in einer Weiterbildung der Erfindung jede zweite Kontaktfläche über die Mitte des Kontaktfeldes auf der Fläche des Kontaktfeldes miteinander verbunden und die Verbindung wie eine Kontaktfläche ausgestaltet. In Fig. 1 besteht die Verbindung aus einer Kupferbahn 14, die durch eine Leitlack-Bahn 15 - in gleicher Weise wie die Kupferflächen 12 - durch die Kontaktflächen 13 überdeckt wird. In die Anordnung nach Fig. 5 sind die Kupferbahnen nicht dargestellt; sie werden in gleichartiger Weise wie in Fig. 1 ausgeführt.

Folgende Abmessungen haben sich nach eingehender Erprobung für das Kontaktfeld einer der Norm für Schreibmaschinen entsprechenen Tastatur als besonders günstig erwiesen: Die Kontaktbrücke 21 ist kreisförmig mit einem Durchmesser von 3,5 mm. Die Kupferflächen 12 sind kreisrund mit einem Durchmesser von 1,575 mm und liegen mit ihren Mittelpunkten auf einem Quadrat mit der Kantenlänge von 2,7 mm. Die Kontaktflächen 13 sind quadratisch mit einer Kantenlänge von 2,044 mm und haben abgerundete Ecken. Zwei diagonal gegenüberliegende Kupferflächen sind durch einen Kupfersteg der Breite 0,3 mm verbunden. Entsprechend werden die Kontaktflächen durch einen Steg aus Karbonlack von 0,6 mm Breite verbunden. Die beiden anderen Kontaktflächen sind an der diesem Steg zugewandten Seite nicht abgerundet, sondern abgeschrägt, so daß ihr Abstand zum Steg 0,512 mm beträgt. Der Abstand der Kontaktflächen beträgt längs einer Seite 0,685 mm. Damit haben die Kanten der Kontaktflächen mindestens 0,5 mm Abstand und die Flächen selbst sind mindestens 0,5 mm breit, so daß für den Auftrag des Leitlacks bekannte und für die Lötstopmaske und den Bestückungsdruck vorhandene Einrichtungen verwendet werden können. Die Lötstop-Freilegung hat eine Kantenlänge von 4,496 mm und abgerundete Ecken.

## Patentansprüche

1. Kontaktfeld für elektrische Taster und Schalter, bei dem Kontaktflächen (13, 13a) durch einen leitfähigen Kontaktstempel (22) verbunden werden, wobei
- die Kontaktflächen (13, 13a) symmetrisch um den Mittelpunkt des Kontaktfelds angeordnet sind,
- diagonal gegenüberliegender Paare von Kontaktflächen (13, 13a) elektrisch verbunden sind,
dadurch gekennzeichnet, daß
- die Kontaktflächen (13, 13a) als zwei Paare von konvexen Flächenstücken ausgebildet sind,
- mindestens ein diagonal gegenüberliegendes Paar von Kontaktflächen (13) einen wesentlichen Teil der Mitte des Kontaktfeldes freiläßt.

2. Kontaktfeld nach Anspruch 1, wobei die Mittelpunkte der Kontaktflächen (13, 13a) etwas außerhalb des durch den Kontaktstempel (22) erreichten Wirkungsfeldes (16) liegen.

3. Kontaktfeld nach Anspruch 1 oder 2, wobei Kontaktflächen (13, 13a) im wesentlichen quadratisch sind und die lichten Abstände zwischen den Kanten der Kontaktflächen (13, 13a) zwischen der Hälfte und einem Fünftel der Seitenlänge der Kontaktflächen betragen.

4. Kontaktfeld nach einem der vorhergehenden Ansprüche, wobei eines der Paare von Kontaktflächen (13a) durch die Mitte des Kontaktfeldes in der Ebene der Kontaktflächen durch einen Steg (14, 15) miteinander verbunden ist, der als zusätzliche Kontaktfläche (15) ausgebildet ist, und die zu dem Steg gerichteten Ecken der anderen beiden Kontaktflächen (13) abgeschrägt sind.

5. Kontaktfeld nach einem der Ansprüche 3 oder 4 mit folgenden ungefähren Maßen für die Kontakflächen (13, 13a) und den Steg (15): Kantenlänge der Kontaktflächen 2mm, lichter Abstand 0,7mm, Entfernung der Mittelpunkte benachbarter Kontaktflächen 2,7mm, Stegbreite 0,6mm.

6. Kontaktfeld nach einem der Ansprüche 1 bis 5, wobei die Kontaktflächen (13, 13a) aus elektrisch leitfähigem Lack, vorzugsweise einem Karbonlack, bestehen.

7. Kontaktfeld nach Anspruch 6, wobei die Kontaktflächen (13, 13a) über vorzugsweise kreisrunden Kupferflächen (12) aufgetragen sind und diese allseits überlappen.

## Claims

1. Contact zone for electrical pushbutton switches and switches, in the case of which contact surfaces (13, 13a) are connected by a conductive contact punch (22),
- the contact surfaces (13, 13a) being arranged symmetrically about the centre point of the contact zone,
- diagonally opposite pairs of contact surfaces (13, 13a) being electrically connected,
characterized in that
- the contact surfaces (13, 13a) are designed as two pairs of convex surface elements,
- at least one diagonally opposite pair of contact surfaces (13) leaves a considerable part of the centre of the contact zone bare.

2. Contact zone according to Claim 1, the centre points of the contact surfaces (13, 13a) being situated slightly outside the effective zone (16) attained by the contact punch (22).

3. Contact zone according to Claim 1 or 2, contact surfaces (13, 13a) being essentially square and the clear spacings between the edges of the contact surfaces (13, 13a) being between half and a fifth of the lateral length of the contact surfaces.

4. Contact zone according to one of the preceding claims, one of the pairs of contact surfaces (13a) being connected together by a web (14, 15) through the centre of the contact zone in the plane of the contact surfaces, which web is designed as an additional contact surface (15), and the corners, directed toward the web, of the other two contact surfaces (13) being bevelled.

5. Contact zone according to either of Claims 3 and 4, having the following approximate dimensions for the contact surfaces (13, 13a) and the web (15): edge length of the contact surfaces 2 mm, clear spacing 0.7 mm, distance between the centre points of adjacent contact surfaces 2.7 mm, web width 0.6 mm.

6. Contact zone according to one of Claims 1 to 5, the contact surfaces (13, 13a) comprising electrically conductive lacquer, preferably a carbon lacquer.

7. Contact zone according to Claim 6, the contact surfaces (13, 13a) being applied over preferably circular copper surfaces (12) and overlapping the latter on all sides.

## Revendications

1. Champ de contact pour palpeurs et interrupteurs électriques, dans lequel les surfaces de contact (13, 13a) sont reliées par un poussoir de contact (22) conducteur, dans lequel
- les surfaces de contact (13, 13a) sont disposées symétriquement autour du centre du champ de contact,
- des paires opposées diagonalement de surfaces de contact (13, 13a) sont reliées électriquement,
caractérisé en ce que
- les surfaces de contact (13, 13a) sont constituées de deux paires d'éléments de surface convexes,
- au moins une paire opposée diagonalement de surfaces de contact (13) laisse libre une partie importante du centre du champ de contact.

2. Champ de contact selon la revendication 1, dans lequel le centre des surfaces de contact (13, 13a) est un peu en dehors du champ d'action (16) atteint par le poussoir de contact (22).

3. Champ de contact selon les revendications 1 ou 2, dans lequel les surfaces de contact (13, 13a) sont pratiquement carrées et les distances libres entre les côtés de surfaces de contact (13, 13a) atteignent entre la moitié et le cinquième de la longueur de côté des surfaces de contact.

4. Champ de contact selon l'une des revendications précédentes, dans lequel une des paires de surfaces de contact (13a) est reliée par le centre du champ de contact, dans le plan des surfaces de contact, par une barrette (14, 15), qui constitue comme une surface de contact (15) supplémentaire et qui est biseautée dans la direction des coins tournés vers la barrette des deux autres surfaces de contact (13).

5. Champ de contact selon l'une des revendications 3 ou 4 ayant les dimensions approximatives suivantes pour les surfaces de contact (13, 13a) et la barrette (15) : longueur des côtés des surfaces de contact 2 mm, distance libre 0,7 mm, distance par rapport au centre de surfaces de contact voisines 2,7 mm, largeur de la barrette 0,6 mm.

6. Champ de contact selon l'une des revendications 1 à 5, dans lequel les surfaces de contact (13, 13a) sont constituées d'un vernis électriquement conducteur, de préférence d'un vernis de carbonado (Karbonlack).

7. Champ de contact selon la revendication 6, dans lequel les surfaces de contact (13, 13a) sont appliquées sur des surfaces de contact en cuivre (12) de préférence circulaires et les dépassent de tous les côtés.
